(19) Europäisches Patentamt

European Patent Office

Office européen des brevets

(11) **EP 1 280 272 B1**

(12) **EUROPEAN PATENT SPECIFICATION**

(45) Date of publication and mention
of the grant of the patent:
**12.01.2005 Bulletin 2005/02**

(51) Int Cl.⁷: $H03F\ 1/32$, $H04L\ 27/36$

(21) Application number: **02016408.3**

(22) Date of filing: **22.07.2002**

(54) **Method for the linearization of the power stage of a signal transmitter and correponding system**

Verfahren zur Linearisierung der Leistungsstufe eines Senders und entsprechendes System

Procédé de linéarisation d'un étage de puissance d'un émetteur et système correspondant

(84) Designated Contracting States:
**AT BE BG CH CY CZ DE DK EE ES FI FR GB GR
IE IT LI LU MC NL PT SE SK TR**

(30) Priority: **27.07.2001 IT MI20011631**

(43) Date of publication of application:
**29.01.2003 Bulletin 2003/05**

(73) Proprietor: **Siemens Mobile Communications
S.p.A.
20126 Milano (IT)**

(72) Inventors:
• **Colombo, Roberto
20081 Abbiategrasso (IT)**
• **Di Donna, Giambattista
20064 Gorgonzola (IT)**
• **Pagliaro, Silvio
65124 Pescara (IT)**

(74) Representative: **Giustini, Delio et al
Siemens Mobile Communications S.p.A.
Postfach 22 16 34
80506 München (DE)**

(56) References cited:
WO-A-98/28888   US-A- 5 910 965
US-B1- 6 173 161

**Description**

<u>Field of the invention</u>

The present invention relates to signal transmission techniques, in particular in the context defined by the preamble of claim 1.

The invention has been developed with particular attention to the possible use in transmission systems in which the transmitter stage susceptible to alter the transmitted signals consists of the final power stage (High Power Amplifier or HPA) of a microwave transmitter employed in a point to point (Point-To-Point or PTP) or point- to-multipoint (Point-to-MultiPoint or PMP) radio connection.

The signal alteration action made by such a stage can essentially be referable to a distortion. Negative effects of said distortion are particularly perceived when a linear modulation format is used for transmission, such as a M-QAM format, in the case of digital signals.

<u>Background art</u>

It is already known how to face this problem implementing, at the transmitter side, a pre-treatment of signals with counteracting function of the alteration action made by the power stage HPA. This can be made through non-linear circuits implemented at intermediate frequency (IF) or at radio frequency (RF) placed upstream the power stage and susceptible to perform a predistortion action according to a complementary characteristic in respect of the distortion characteristic of the power stage.

As an alternative to the use of fixed predistortion circuits (implementing an essentially empirical and static linearization process, which does not enable to follow possible phenomena of thermal drift and aging) in the course of the years, techniques foreseeing to employ predistorters of digital type circuits have been proposed, implemented at base band level in the modulator. These circuits are controlled in adaptive mode - according to a general feedback scheme - by a control signal obtained comparing the samples of the digital signal applied to the predistorter input with corresponding samples of the signal at the power stage output.

The relevant literature is extremely wide, as demonstrated, for instance, by the paper by G. Karam and H. Sari, "Oversampled signal predistortion for digital radio systems with arbitrary transmit pulse shaping", 3rd ECRR Proceedings, Paris, pp 255-261, December 1991.

The main disadvantage of this solution (disadvantage that considerably limited the practical application of the same) is represented by the fact that, to obtain the control signal adapted to pilot the predistorter action, it is necessary to convert the output signal of the distorting power stage into a signal that can be used to control the predistorter. Beyond strictly technological aspects (the output signal to convert is usually a high frequency signal, typically a microwave one, while the control signal of the predistorter typically consists of a signal in base band converted into digital form), the feedback chain necessary to produce the control signal is a circuit set to all effects, an additional set compared to the transmitter basic diagram and therefore susceptible to negatively affect the complexity, reliability and mainly the cost of the transmitter.

Other known solutions foresee that the pre-treatment implemented at transmitter level (for instance through a predistorter implemented at base band level in the modulator) is piloted in an adaptive manner by a control signal generated in the receiver (typically at demodulator side) and retransmitted towards the transmitter.

The main advantage offered by these solutions is given by the fact that the control signal used to pilot the pre-treatment is generated starting from signals already available in the receiver, without requiring the provision of additional circuits. Also concerning the retransmission of the control signal towards the transmitter, one of the service channels usually foreseen in such a connection can also be employed. The above, also, with a very limited occupation of the available resources (for instance, in terms of service channel frames), considering that - once correctly initialised - the predistorter control process is a phenomenon having a rather slow time evolution.

International patent application WO 98/28888 discloses a method which makes use of two polynomial interpolators up to third order which approximate the I and Q components of the received constellation points. The polynomial coefficients are adaptively calculated by minimizing the mean square error between the expected points and the received ones. In detail, at the receiver the. statistic regarding the positions, sizes, and shapes of the symbol clusters are measured on a periodic basis, and are sent via a reverse control channel to the DSP of the transmitter. The latter calculates the parameters of the constellation distortion that arise in the forward channel and receiver. These parameters are used to adjust the I-Q coordinates of the transmitted symbols in an adaptive predistorter so as to minimize the resulting received distortions. The algorithm is designed to compensate all the system impairments in grade of shifting the actual centres of the observed measurement clusters from the ideal locations in the constellation plot. For instance: noise, ISI, multipath fading, biases, gain imbalances, lock and quad angle errors, other then nonlinear effects.

The major drawback of this method is that what impairments affect the distorted constellation are not generally known a priori, so the wide target of compensating all of them implies the calculation of 7+7 coefficients of the third order polynomial. The accumulation of a sufficient statistic for the least-square error estimation of the 14 unknown parameters involves the handling of large algebraic matrices. Multiple linear regression is used for estimating those parameters and at least a cumbersome matrix inversion is needed.

US patent US 5910965 A1 discloses a method which exploits the non-random distribution of the received signal when it is affected by the nonlinearity, focusing on the fact that each constellation point fall outside the space defined in linearity conditions. In detail, a larger square B superimposed to a smaller A is a representation of all the possible points of the received constellation in whatever conditions. The square A is the space of the linear constellation while B also includes trespassing due to non-linearities. The space A is defined by a random distribution of the constellation points while B by a non-random one. Each time a detected point falls in space B a counting is incremented and the nonlinear data is latched. The counting may continue with the result being a zero count when the BER (Bit Error Rate) is good and a higher count as the signal degrades. The counts from both the I and Q axes are sampled and fed to the predistorter. The latter changes the phase and/or amplitude as needed, and another count is taken. Latch change made and the resulting count are placed in a memory. The process is repeated and the DSP determines which correction provides the count closest to zero (best performance). As the number of samples increases and the count improves, the predistorter converges on optimum performance.

Major drawback of this method is the large delay to converge towards a reliable corrective action. This because the two squares representations of the possible constellation points is a too simplified representation of the underlying statistic; in the reality only when a large extent of data is observed the distorted ones tend to fall into the outer space of the distribution.

### Scope and summary of the invention

Scope of the present invention is to offer a solution capable of overcoming the above-mentioned drawback.

According to the present invention, this purpose is reached thanks to a method having the additional characteristics specifically recalled in the appended claims. The invention relates also to the corresponding system.

According to the invention, the structure of the predistorter is based on a Volterra's series without memory truncated at the fifth order. It is also possible to use higher order terms; in general, these do not contribute in a significant way to improve the system operation characteristics. It is foreseen that the control signal essentially corresponds to distortion terms of the third and fifth order generated in digital form starting from the linear signal in base band in the demodulator. In general, in fact, the predistorter has the characteristics of a three-taps equalizer in which the tap relevant to the linear term is constant and real, while the taps of the third and fifth order (generally having the characteristics of a complex coefficient, including a real and an imaginary part) are subjected to the control signal coming from the demodulator in order to obtain the correct complex weighing factor, reversing the characteristic distorting the transmitter stage, or minimizing the signal to mean square error ratio (S/MSE) at the receiver side.

The solution according to the invention is generally applicable to all the techniques where the implementation of a signal pre-treatment counteracting the alteration action made on such signals by a transmitter stage is foreseen.

By comparison with the method disclosed in WO 98/28888, the method of the present invention is faster because the delay due to fill up with incoming data a large statistic matrix is unnecessary. Besides, the method is more effective to the limited extent of compensating the effect of the non-linearities without memory; in fact only 2+2 unknown polynomial coefficients have to be calculated instead of 7+7 and only few multiplications instead of a cumbersome matrix inversion are needed.

By comparison with the method disclosed in US 5910965 A1, the method of the present invention is faster because the delay due to observe a large extent of data for a reliable detection of the effect of the nonlinear distortion on the constellation points is totally unnecessary.

### Brief description of figures

The invention shall be now better understood from the following description given as an example, but not limited to the same, together with the attached figures, in which:

- Figure **1** and **2** are block diagrams representing the structure of the transmitter and receiver, respectively, of a transmission system operating according to the invention, and
- Figure **3** is a diagram showing the operation characteristics that can be noticed in a system according to the invention.

Detailed description of a preferred embodiment of the invention.

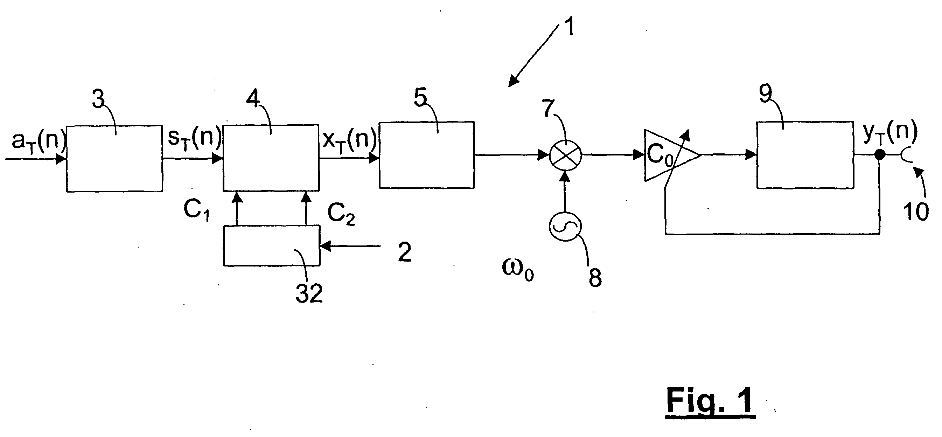

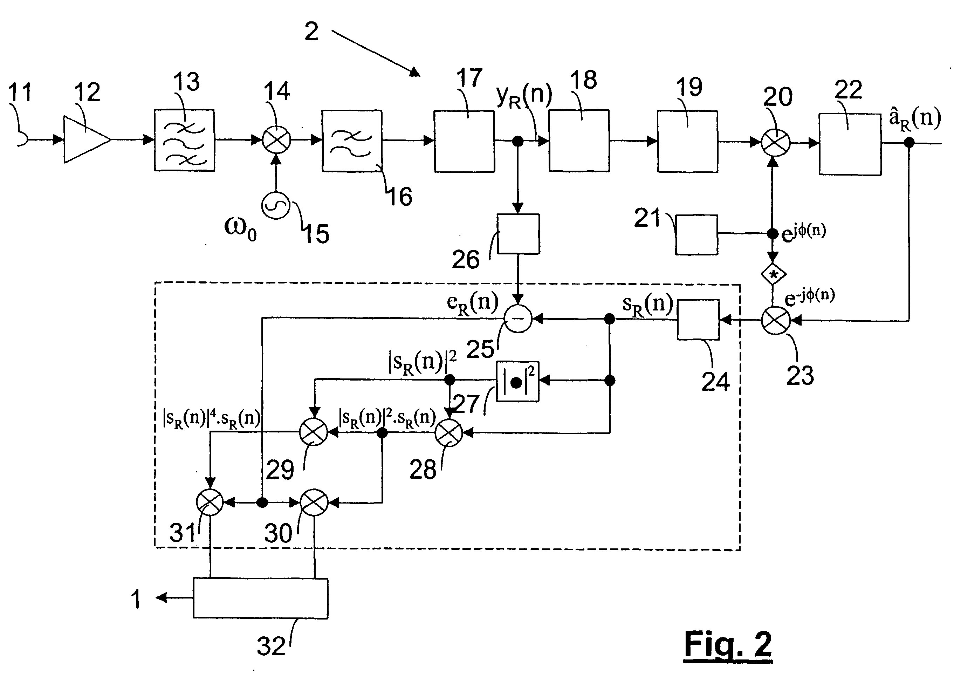

In the block diagrams of figures 1 and 2, the references 1 and 2 indicate a transmitter and a receiver, respectively, included in a system for the transmission of digital signals. To settle the idea, it can be a connection on radio link of the PTP or PMP type employing a linear modulation format, such as for instance M-QAM.

The flow of data at input $a_T(n)$ feeds a transmission filter 3 that generates a corresponding transmission signal $s_T(n)$ in base band adapted to supply a predistorter 4.

The signal $x_T(n)$ obtained at the predistorter 4 output is sent to a digital-to-analogue converter 5 to be then transferred to a modulator in quadrature 7 operating at the frequency (pulsation) $\omega_0$ generated by a local oscillator 8. The modulated signal so obtained is transferred to a power stage (HPA), denoted with 9, to be sent towards a transmitting antenna 10. A variable gain pre-amplifier $C_0$ placed upstream the power stage 9 inside an AGC (Automatic Gain Control) loop, is visible in fig.1.

The scheme described must be considered well known, both concerning the general architectural organization, and for the specific characteristics of the single devices 3 to 5 and 7 to 10 here considered.

In particular, this is worth also for the control signal used to pilot the predistorter 4. For reasons that shall result clearer in the continuation of the description, this signal is actually identified with two coefficients $C_1$ and $C_2$. These coefficients, which in general have the character of complex variables, can be obtained according to any of the criteria known to this purpose: in this respect, reference can be made to the volume by S. Benedetto, E. Biglieri and V. Castellani, "Digital Transmission Theory", Englewood Cliffs, NJ; Prentice-Hall, 1987.

Preferably, the predistorter 4 is implemented with digital circuits in the base band section of the transmitter, immediately after the transmission filter (FIR TX) 3 and immediately before the digital-to-analogue conversion represented by block 5 of figure 1.

Since this is a non linear system without memory (like the power stage 9), the predistorter 4 can be described with an input/output relation of the following type:

$$x_T(n) = s_T(n) + C_1\left|s_T(n)\right|^2 s_T(n) + C_2\left|s_T(n)\right|^4 s_T(n)$$

where $s_T(n)$ is the signal coming out from the FIR TX 3 at the predistorter 4 input and $x_T(n)$ is the signal coming out from the latter - destined to be fed to the converter 5 - stopped at the distortion term of the fifth order.

In the block diagram of the receiver 2, the reference 11 indicates the receiving antenna. The signal received is caused to pass through a reception amplifier 12 and a noise rejection filter 13 to be then (re)converted in base band. This occurs by mixing, made in a mixer 14, with a local oscillator signal at the frequency (pulsation) $\omega_0$ coming from an oscillator 15 and subsequent filtering 16 in view of the conversion to digital made in an analogue-to-digital converter 17.

At the output of the latter, a signal received and converted in base band $y_R(n)$ is therefore available.

Proceeding in the normal reception chain of the receiver, the numeric reference 18 indicates a reception filter (FIR RX), whose output signal is transferred by a base band equalizer 19.

All the above shall then be multiplied in a complex rotator 20 with a carrier synchronization signal coming from a PLL 21 performing the frequency and the transmission carrier phase recovery.

The signal so obtained is transferred to a decision block 22 generating at its output the sequence of (estimated) symbols received.

What described corresponds to a well-known receiver structure, both concerning the architecture of the same, and for the implementation characteristics of the single blocks 12 to 22 considered.

It could be noticed that in figure 1 and 2 the phase and quadrature channels (I and Q) included both in the transmitter 1 and in the receiver 2 have not been separately represented for drawing compactness and representation convenience. In any case - as those skilled in the art will easily identify - the signal in transit, and in particular the signal in transit in the portion of transmission and reception base band is in general a complex signal, as complex are in general the coefficients of the different filters/equalizers considered (of course, in addition to the coefficients of predistorter 4).

The solution according to the invention grounds on the acknowledgment of the fact that, since there is no element with memory between the output of predistorter 4 and the power stage (HPA) 9, the output of the latter, denoted $y_T(n)$ is a narrow band signal.

Therefore, the following expression for the equivalent low pass applies to the latter:

$$y_T(n) = b_0 s_T(n) + b_1\left|s_T(n)\right|^2 s_T(n) + b_2\left|s_T(n)\right|^4 s_T(n) + ...$$

Consequently, the equivalent low-pass of the signal received is given by:

$$y_R(n) = y_T(n)\text{©}f(n) + \eta(n) = b_0 s_T(n)\text{©}f(n) + b_1|s_T(n)|^2 s_T(n)\text{©}f(n) +$$

$$b_2|s_T(n)|^4 s_T(n)\text{©}f(n) + ... + \eta(n)$$

where:

- $b_i$ are (complex) constants of the development,
- $\eta(n)$ is a white and additive Gaussian noise, and
- f(n) is the impulse response of the channel including all the radio frequency and intermediate frequency filters of the transmission and reception chain (with the sole exception of shaping filters).

Of course, the symbol © indicates the convolution operation.

The first term of the expression of $y_R(n)$ represents the linear component; the second term is the distortion component of the third order, the third one is the filth order component, and so on.

The target to attain is of course that to minimize the total content of terms different from the first one, appropriately adjusting the coefficients $C_i$ of predistorter 4.

In the solution according to the invention, the linear component of the expression of $y_R(n)$ is reconstructed at demodulator level in the shape of a signal $s_R(n)$ obtained starting from the decided symbols a(n) available at the output of the decision circuit 22 de-rotated in a complex rotator 23 of the phase $\phi(n)$ of carrier recovery (PLL) and filtered in a filter FIR AUX 24 whose coefficients are initialised at the same values of the homologue filter FIR TX 3 present in transmitter 1.

For the signal $s_R(n)$, which can be seen as a model of signals $y_R(n)$, reconstructed on the basis of "decided" symbols, the following expression applies:

$$s_R(n) = \Sigma_k g(k)a_R(n-k)e^{-j\phi(n-k)}$$

In a sum node denoted with 25 an error signal $e_R(n) = y_R(n)-s_R(n)$ is reconstructed for each symbol received.

It shall be remembered that the signal $y_R(n)$ is available at the output of the analogue-to-digital converter 17 properly delayed in 26 up to the time alignment with the reconstructed signal $s_R(n)$.

The reference 27 indicates a block in which the squared module of the signal $s_R(n)$ is calculated, while references 28 to 31 indicate corresponding multipliers whose connection diagram - that can be clearly obtained from the drawing - is such to originate at the output of multipliers 30 and 31, respectively, correlation coefficients $C_i$ that can be expressed according to the relation

$$C_i = \langle e(n)|s_R(n)|^{2i}s_R^*(n)\rangle \qquad \text{for } i = 1, 2$$

where symbol $^*$ indicates complex conjugated.

The correlation coefficients $C_i$ essentially form the control signal, which when retransmitted towards the transmitter 1, can be used to generate the coefficients of predistorter 4, this performing the relevant adaptive control.

The transmission occurs through a chain of transmission elements denoted as a whole with 32 and made of elements of the known type: these are in fact the same elements generally available in a system 1, 2 of the type described for the transmission of service signals.

The calculation of the correlations defining coefficients $c_i$ (we remember that - at least in principle - it is also possible to calculate coefficients of higher order, which however do not generally contribute in a significant way to additionally improve the system performances) is made at each new frame in view if retransmission towards the transmitter 1.

Here the coefficients of predistorter 4 are reconstructed accumulating the values of the relevant correlations according to a recursive expression of the type:

$$C_i(N_T+1) = C_i(N_T)-\beta c_i \qquad \text{for } i = 1, 2$$

where $N_T$ is the frame time and $\beta$ an appropriate step size factor.

The correct operation of the system foresees also the adjustment of coefficients $g_k$ of the filter 24. In general, this occurs according an expression of the following type

$$g_k(n+1) = g_k(n) + \gamma \varepsilon(n) \hat{a}_R^*(n-k) e^{j\phi(n-k)}$$

where $\gamma$ is an appropriate step size factor.

This last operation is important in order that, at the end of the linearization process, $s_R(n)$ is as close as possible to $s_T(n) \copyright f(n)$, therefore validating the capacity of the demodulator to reconstruct at its best the linear component of the received signal $y_R(n)$.

The experiences made by the Applicant, referring, as power stage 9, to a progressive wave amplifier (whose non-linear characteristic results more severe than that of solid state amplifiers) enabled to check the effectiveness of the proposed solution.

In particular, reference has been made to the criterion proposed in the paper of Karam and Sari, already mentioned above, which consists in the evaluation of the degrading of the signal/noise ratio obtained at a pre-set BER value (for instance 0.001).

It has been noticed that the solution according to the invention, implemented having recourse to a two tap predistorter 4, enables to obtain - compared to a system without predistortion function - a gain in the range of approximately 6 dB in terms of total degradation with a gain in terms of output back-off (defined as the difference in dB between the average power transmitted and the maximum saturation power at the HPA output) in the range of 5 dB approx.

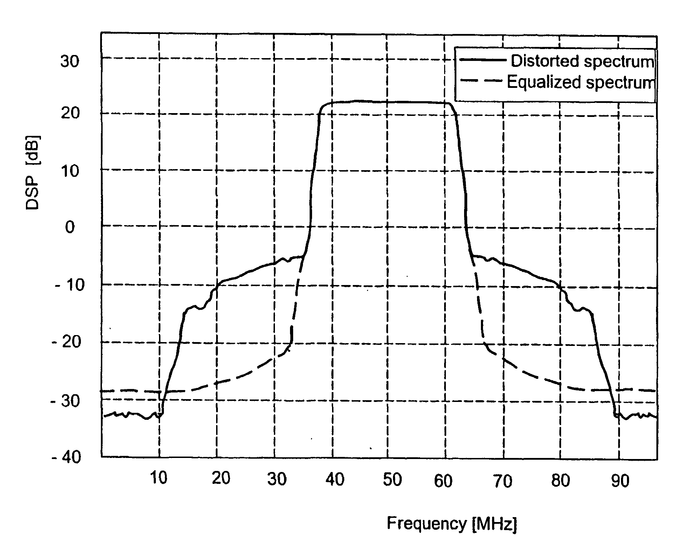

The diagram in figure 3 shows the effect of the linearization technique implemented according to the invention on the spectrum of the signal coming out from the HPA for an output back-off (OBO) of 6 dB.

In particular, the diagram of figure 3 refers to the 128 QAM modulation format with roll-off equal to 0,18.

Therefore, while an embodiment of the present invention has been shown and described, it should be understood that other embodiments and/or additions can be made by those skilled in the art without departing from the scope thereof.

**Claims**

1. Method for compensating signal distortions generated by a device (9) inside a transmitter (1) connected to a receiver (2), including the step of adaptively predistorting (4) a signal to be transmitted ($s_T(n)$) before it crosses said distorting device (9), the predistortion function being controlled by a feedback control signal ($C_1$, $C_2$) generated inside the receiver (2) on the basis of a decision signal ($\hat{a}_R(n)$) corresponding to an estimate of the signal ($a_T(n)$) at the input of the transmitter (1), **characterized in that** it further includes the following steps executed by the receiver:

   - reconstructing (23, 24) a reference model ($s_R(n)$) of the transmitted signal ($y_T(n)$), as it is received ($y_R(n)$) by the receiver (2), starting from said decision signal ($\hat{a}_R(n)$);
   - generating (25) an error signal ($e_R(n)$) indicative of the difference between said received signal ($y_R(n)$) and said reference model ($s_R(n)$); and
   - correlating said reference model ($s_R(n)$) and said error signal ($e_R(n)$) for generating said control signal ($C_1$, $C_2$) sent backward to the transmitter (1).

2. The method of the preceding claim, **characterized in that** said correlating step calculates the correlations ($C_1$, $C_2$) of the third and fifth order of said reference model ($s_R(n)$) and said error signal ($e_R(n)$) according to the relation:

$$C_i = <e(n)|s_R(n)|^{2i} s_R^*(n)> \qquad i = 1, 2$$

where: $C_i$ are the coefficients of the correlations, $e(n)$ is the error signal, $s_R(n)$ is the reference model, and symbol $*$ indicates complex conjugated.

3. The method of the preceding claim, **characterized in that** the coefficients $C_i$ are obtained by accumulating the values of the relevant correlation coefficients ($C_1$, $C_2$) according to a recursive expression of the type:

$$C_i(N_T+1) = C_i(N_T)\beta C_i \qquad i = 1,2$$

where $N_T$ is a frame time and $\beta$ an appropriate step size factor.

4.  The method of the preceding claim, **characterized in that** the predistortion input/output function is of the type:

$$x_T(n)= s_T(n)+C_1\left|s_T(n)\right|^2 s_T(n)+C_2\left|s_T(n)\right|^4 s_T(n)$$

where: $s_T(n)$ is the input signal, $x_T(n)$ is the output signal, and $C_1$, $C_2$ the correlation coefficients of the third and fifth order, respectively.

5.  The method of one of the preceding claims, **characterized in that** the reconstructing step includes a de-rotation $(e^{-j\phi(n)})$ of said decision signal $(â_R(n))$ of the phase of the recovered carrier $(e^{j\phi(n)})$.

6.  The method of one of the preceding claims, **characterized in that** said decision signal $(â_R(n))$ undergoes an adaptive filtering (24) modelling the transmission channel.

7.  The method of the preceding claim, **characterized in that** said filtering (24) is implemented according to a filtering function FIR.

8.  The method of the preceding claim, **characterized in that** the coefficients of the FIR are adjusted according an expression of the following type:

$$g_k(n+1) = g_k(n)+\gamma\varepsilon(n)\ â_R{}^*(n\text{-}k)e^{j\phi(n\text{-}k)}$$

where: $g_k$ are the coefficients of the FIR, $e(n)$ is the error signal, $\gamma$ is an appropriate step size factor, $â_R$ is the decision signal, $\phi$ is the phase of the recovered carrier $(e^{j\phi(n)})$, and symbol * indicates complex conjugated.

9.  System for the compensation of signal distortions generated by a distorting device (9) inside a transmitter (1) connected to a receiver (2),
    the transmitter (1) including:

    -   predistorting means (4) placed upstream said distorting device (9), responsive to a control signal $(C_i)$ for counteracting the distortions introduced by said distorting device (9);
    -   means (32) for receiving said control signal $(C_i)$ on a reverse channel; and

    the receiver (2) including:

    -   means (12 to 17) for the reception of the transmitted signal $(y_T(n))$;
    -   decision means (18 to 22) for obtaining from the received signal $(y_R(n))$ a decision signal $(â_R(n))$ corresponding to an estimate of the signal $(a_T(n))$ at the input of the transmitter (1);
    -   control means (23 to 31) cooperating with said decision means (18 to 22) for the generation of said control signal $(C_i)$;
    -   means (32) for the transmission of said control signal $(C_i)$ on the reverse channel;

    **characterized in that** said control means (23 to 31) include:

    -   means (23, 24) for reconstructing a reference model $(S_R(n))$ of the transmitted signal $(y_T(n))$, as it is received $(y_R(n))$ by the receiver (2), starting from said decision signal $(â_R(n))$;
    -   means (25, 26) for generating an error signal $(e_R(n))$ indicative of the difference between the received signal $(y_R(n))$ and said reference model $(s_R(n))$, and
    -   means (27 to 31) for correlating said reference model $(s_R(n))$ and said error signal $(e_R(n))$ obtaining said control signal $(C_i)$.

10. The system of the preceding claim, **characterized in that** said distorting device (9) is a radio frequency power amplifier.

11. System according to claim 9 or 10, **characterized in that** said correlating means (27 to 31) includes:

- squarer means (27) for calculating the square module of said reference model ($s_R(n)$);
- a first multiplier (28) of the output of said squarer means (27) by the reference model ($s_R(n)$);
- a second multiplier (29) of the output of the squarer means (27) by the output of the first multiplier (28);
- a third multiplier (30) of the output of the first multiplier (28) by said error signal ($e_R(n)$), obtaining third order correlation coefficients ($C_1$) of the reference model ($s_R(n)$) and the error signal ($e_R(n)$); and
- a fourth multiplier (31) of the output of the second multiplier (29) by said error signal ($e_R(n)$), obtaining fifth order correlation coefficients ($C_1$) of the reference model ($s_R(n)$) and the error signal ($e_R(n)$).

12. System according to any claims from 9 to 11, **characterized in that** said reconstructing means (*, 23, 24) includes means (*, 23) for carrying out a de-rotation ($e^{-j\phi(n)}$) of said decision signal ($â_R(n)$) of the phase of the recovered carrier ($e^{j\phi(n)}$).

13. System according to the preceding claim, **characterized in that** said reconstructing means (*, 23, 24) include a FIR filter (24) with adaptive coefficients for filtering the de-rotated decision signal.


**Patentansprüche**

1. Verfahren zur Kompensation von Signalverzerrungen, die von einem Gerät (9) innerhalb eines Senders (1) erzeugt werden, der mit einem Empfänger (2) verbunden ist, welches den Schritt eines adaptiven Vorverzerrens (4) eines zu sendenden Signals ($s_T(n)$), bevor dieses das besagte verzerrende Gerät (9) durchläuft, umfasst, wobei die Vorverzerrungs-Funktion durch ein Rückkopplungssignal ($C_1$, $C_2$) gesteuert wird, das im Empfänger (2) auf der Basis eines Entscheidungssignals ($â_R(n)$) erzeugt wird, das einer Schätzung des Signals ($a_T(n)$) am Eingang des Senders (1) entspricht, **dadurch gekennzeichnet, dass** es ferner die folgenden vom Empfänger ausgeführten Schritte umfasst:

- Rekonstruieren (23, 24) eines Referenzmodells ($s_R(n)$) des gesendeten Signals ($y_T(n)$), so wie es durch den Empfänger (2) empfangen wird ($y_R(n)$), ausgehend von dem besagten Entscheidungssignal ($â_R(n)$);
- Erzeugen (25) eines Fehlersignals ($e_R(n)$), das auf die Differenz zwischen dem besagten empfangenen Signal ($y_R(n)$) und dem besagten Referenzmodell ($s_R(n)$) schließen lässt; und
- Korrelieren des besagten Referenzmodells ($s_R(n)$) und des besagten Fehlersignals ($e_R(n)$) zur Erzeugung des besagten Steuersignals ($C_1$, $C_2$), das zum Sender (1) zurückgesendet wird.

2. Verfahren nach dem vorhergehenden Anspruch, **dadurch gekennzeichnet, dass** in dem besagten Schritt des Korrelierens die Korrelationen ($C_1$, $C_2$) der dritten und fünften Ordnung des besagten Referenzmodells ($s_R(n)$) und des besagten Fehlersignals ($e_R(n)$) gemäß der Beziehung

$$C_i = \langle e(n) |s_R(n)|^{2i} S_R^{*}(n)\rangle \qquad i = 1, 2$$

berechnet werden, wobei $C_i$ die Korrelationskoeffizienten sind, $e(n)$ das Fehlersignal ist, $s_R(n)$ das Referenzmodell ist und das Symbol $^{*}$ den konjugiert komplexen Wert bezeichnet.

3. Verfahren nach dem vorhergehenden Anspruch, **dadurch gekennzeichnet, dass** die Koeffizienten $C_i$ erhalten werden, indem die Werte der entsprechenden Korrelationskoeffizienten ($C_1$, $C_2$) gemäß einer rekursiven Beziehung des Typs

$$C_i(N_T+1) = C_i(N_T)-\beta C_i \qquad i= 1, 2$$

akkumuliert werden, wobei $N_T$ eine Frame-Zeit ist und $\beta$ ein geeigneter Schrittweitenfaktor ist.

4. Verfahren nach dem vorhergehenden Anspruch, **dadurch gekennzeichnet, dass** die Eingangs-Ausgangs-Funktion der Vorverzerrung vom Typ

$$x_T(n) = s_T(n)+C_1|s_T(n)|^2 s_T(n)+C_2|s_T(n)|^4 s_T(n)$$

ist, wobei $s_T(n)$ das Eingangssignal ist, $x_T(n)$ das Ausgangssignal ist und $C_1$, $C_2$ die Korrelationskoeffizienten der dritten bzw. fünften Ordnung sind.

5. Verfahren nach einem der vorhergehenden Ansprüche, **dadurch gekennzeichnet, dass** der Schritt des Rekonstruierens eine Phasenkorrektur ("de-rotation") ($e^{-j\phi(n)}$) des besagten Entscheidungssignals ($\hat{a}_R(n)$) bezüglich der Phase des wiederhergestellten Trägers ($e^{j\phi(n)}$) umfasst.

6. Verfahren nach einem der vorhergehenden Ansprüche, **dadurch gekennzeichnet, dass** das besagte Entscheidungssignal ($\hat{a}_R(n)$) einer adaptiven Filtration (24) unterzogen wird, die den Übertragungskanal modelliert.

7. Verfahren nach dem vorhergehenden Anspruch, **dadurch gekennzeichnet, dass** die besagte Filtration (24) entsprechend einer Filterfunktion FIR implementiert ist.

8. Verfahren nach dem vorhergehenden Anspruch, **dadurch gekennzeichnet, dass** die Koeffizienten der FIR gemäß einem Ausdruck des folgenden Typs angepasst werden:

$$g_k(n+1) = g_k(n) + \gamma\varepsilon(n)\ \hat{a}_R^{*}(n-k)e^{j\phi(n-k)}$$

wobei $g_k$ die Koeffizienten der Filterfunktion FIR sind, $e(n)$ das Fehlersignal ist, $\gamma$ ein geeigneter Schrittweitenfaktor ist, $\hat{a}_R$ das Entscheidungssignal ist, $\phi$ die Phase des wiederhergestellten Trägers ($e^{j\phi(n)}$) ist und das Symbol * den konjugiert komplexen Wert bezeichnet.

9. System zur Kompensation von Signalverzerrungen, die von einem verzerrenden Gerät (9) innerhalb eines Senders (1) erzeugt werden, der mit einem Empfänger (2) verbunden ist, wobei der Sender (1) umfasst:

   - vorverzerrende Mittel (4), die dem besagten verzerrenden Gerät (9), vorgeschaltet sind und die auf ein Steuersignal ($C_i$) reagieren, um den durch das besagte verzerrende Gerät (9) hervorgerufenen Verzerrungen entgegenzuwirken;
   - Mittel (32) zum Empfangen des besagten Steuersignals ($C_i$) auf einem Rückkanal; und

   wobei der Empfänger (2) umfasst:

   - Mittel (12 bis 17) für den Empfang des gesendeten Signals ($Y_T(n)$);
   - Entscheidungsmittel (18 bis 22), um aus dem empfangenen Signal ($y_R(n)$) ein Entscheidungssignal ($\hat{a}_R(n)$) zu gewinnen, das einer Schätzung des Signals ($a_T(n)$) am Eingang des Senders (1) entspricht;
   - Steuermittel (23 bis 31), die mit den besagten Entscheidungsmitteln (18 bis 22) zusammenwirken, zur Erzeugung des besagten Steuersignals ($C_i$);
   - Mittel (32) zur Übertragung des besagten Steuersignals ($C_i$) auf dem Rückkanal;

   **dadurch gekennzeichnet, dass** die besagten Steuermittel (23 bis 31) umfassen:

   - Mittel (23, 24) zum Rekonstruieren eines Referenzmodells ($s_R(n)$) des gesendeten Signals ($y_T(n)$), so wie es durch den Empfänger (2) empfangen wird ($y_R(n)$), ausgehend von dem besagten Entscheidungssignal ($\hat{a}_R(n)$);
   - Mittel (25, 26) zum Erzeugen eines Fehlersignals ($e_R(n)$), das auf die Differenz zwischen dem besagten empfangenen Signal ($y_R(n)$) und dem besagten Referenzmodell ($s_R(n)$) schließen lässt, und
   - Mittel (27 bis 31) zum Korrelieren des besagten Referenzmodells ($s_R(n)$) und des besagten Fehlersignals ($e_R(n)$) zur Erzeugung des besagten Steuersignals ($C_i$).

10. System nach dem vorhergehenden Anspruch, **dadurch gekennzeichnet, dass** das besagte verzerrende Gerät (9) ein Hochfrequenzleistungsverstärker ist.

11. System nach Anspruch 9 oder 10, **dadurch gekennzeichnet, dass** die besagten Mittel zum Korrelieren (27 bis 31) umfassen:

   - Quadrierer-Mittel (27) zum Berechnen des Quadrats des Absolutbetrags des besagten Referenzmodells ($s_R(n)$);

- ein erstes Multiplizierglied (28) zur Multiplikation des Ausgangs des besagten Quadrierer-Mittels (27) mit dem Referenzmodell ($s_R(n)$);
- ein zweites Multiplizierglied (29) zur Multiplikation des Ausgangs des Quadrierer-Mittels (27) mit dem Ausgang des ersten Multipliziergliedes (28);
- ein drittes Multiplizierglied (30) zur Multiplikation des Ausgangs des ersten Multipliziergliedes (28) mit dem besagten Fehlersignal ($e_R(n)$), wobei Korrelationskoeffizienten dritter Ordnung ($C_1$) des Referenzmodells ($s_R(n)$) und des Fehlersignals ($e_R(n)$) erhalten werden; und
- ein viertes Multiplizierglied (31) zur Multiplikation des Ausgangs des zweiten Multipliziergliedes (29) mit dem besagten Fehlersignal ($e_R(n)$), wobei Korrelationskoeffizienten fünfter Ordnung ($C_1$) des Referenzmodells ($s_R(n)$) und des Fehlersignals ($e_R(n)$) erhalten werden.

**12.** System nach einem der Ansprüche 9 bis 11, **dadurch gekennzeichnet, dass** die besagten Mittel zum Rekonstruieren (*, 23, 24) Mittel (*, 23) zur Phasenkorrektur ("de-rotation") ($e^{-j\phi(n)}$) des besagten Entscheidungssignals ($â_R(n)$) bezüglich der Phase des wiederhergestellten Trägers ($e^{j\phi(n)}$) umfassen.

**13.** System nach dem vorhergehenden Anspruch, **dadurch gekennzeichnet, dass** die besagten Mittel zum Rekonstruieren (*, 23, 24) ein Filter FIR (24) mit adaptiven Koeffizienten zur Filtration des phasenkorrigierten Entscheidungssignals umfassen.

**Revendications**

**1.** Procédé pour compenser des distorsions de signaux produites par un dispositif (9) à l'intérieur d'un émetteur (1) relié à un récepteur (2), comprenant l'étape de prédistorsion adaptative (4) d'un signal à émettre ($s_T(n)$) avant qu'il ne traverse ledit dispositif distorsif (9), la fonction de prédistorsion étant commandée par un signal de commande par réaction ($C_1$, $C_2$) produit dans le récepteur (2) sur la base d'un signal de décision ($â_R(n)$) correspondant à une estimation du signal ($a_T(n)$) à l'entrée de l'émetteur (1), **caractérisé en ce qu'**il comprend par ailleurs les étapes suivantes exécutées par le récepteur :

- reconstituer (23, 24) un modèle de référence ($s_R(n)$) du signal émis ($y_T(n)$), tel qu'il est reçu ($y_R(n)$) par le récepteur (2), à partir dudit signal de décision ($â_R(n)$) ;
- produire (25) un signal d'erreur ($e_R(n)$) indicatif de la différence entre ledit signal reçu ($y_R(n)$) et ledit modèle de référence ($s_R(n)$), et
- corréler ledit modèle de référence ($s_R(n)$) et ledit signal d'erreur ($e_R(n)$) pour produire ledit signal de commande ($C_1$, $C_2$) renvoyé à l'émetteur (1).

**2.** Procédé selon la revendication précédente, **caractérisé en ce que** ladite étape de corrélation calcule les corrélations ($C_1$, $C_2$) des troisième et cinquième degrés dudit modèle de référence ($s_R(n)$) et dudit signal d'erreur ($e_R(n)$) selon la relation :

$$C_i = <e(n)|s_R(n)|^{2i}s_R^{*}(n)> \qquad i = 1, 2$$

où : $C_i$ correspond aux coefficients de corrélation, $e(n)$ est le signal d'erreur, $s_R(n)$ est le modèle de référence et le symbole $^{*}$ indique un conjugué complexe.

**3.** Procédé selon la revendication précédente, **caractérisé en ce que** les coefficients $C_i$ sont obtenus en accumulant les valeurs des coefficients de corrélation pertinents ($C_1$, $C_2$) selon une expression récursive du type :

$$C_i(N_T+1) = C_i(N_T)-\beta C_i \qquad i = 1, 2$$

où $N_T$ est une durée de trame et $\beta$, un facteur de pas de progression approprié.

**4.** Procédé selon la revendication précédente, **caractérisé en ce que** la fonction d'entrée/de sortie de prédistorsion est du type :

$$x_T(n) = s_T(n) + C_1 |s_T(n)|^2 s_T(n) + C_2 |s_T(n)|^4 s_T(n)$$

où : $s_T(n)$ est le signal d'entrée, $x_T(n)$ est le signal de sortie et $C_1$, $C_2$ sont les coefficients de corrélation, respectivement, des troisième et cinquième degrés.

5. Procédé selon l'une quelconque des revendications précédentes, **caractérisé en ce que** l'étape de reconstitution comprend un redressement ($e^{-j\phi(n)}$) dudit signal de décision ($\hat{a}_R(n)$) de la phase de la porteuse récupérée ($e^{j\phi(n)}$).

6. Procédé selon l'une quelconque des revendications précédentes, **caractérisé en ce que** ledit signal de décision ($\hat{a}_R(n)$) subit un filtrage adaptatif (24) modélisant la voie d'émission.

7. Procédé selon la revendication précédente, **caractérisé en ce que** ledit filtrage (24) est mis en oeuvre selon une fonction de filtrage FIR.

8. Procédé selon la revendication précédente, **caractérisé en ce que** les coefficients du FIR sont ajustés selon une expression du type suivant :

$$g_k(n+1) = g_k(n) + \gamma\varepsilon(n)\,\hat{a}_R{}^*(n-k)e^{j\phi(n-k)}$$

où : $g_k$ correspond aux coefficients du FIR, $e(n)$ est le signal d'erreur, $\gamma$ est un facteur de pas de progression approprié, $\hat{a}_R$ est le signal de décision, $\phi$ est la phase de la porteuse récupérée ($e^{j\phi(n)}$) et le symbole * indique un conjugué complexe.

9. Système de compensation de distorsions de signal produites par un dispositif distorsif (9) à l'intérieur d'un émetteur (1) relié à un récepteur (2), l'émetteur (1) comprenant :

 - un moyen de prédistorsion (4) placé en amont dudit dispositif distorsif (9), asservi à un signal de commande ($C_i$) pour neutraliser les distorsions introduites par ledit dispositif distorsif (9) ;
 - un moyen (32) pour recevoir ledit signal de commande ($C_i$) sur une voie de retour, et

 le récepteur (2) comprenant :

 - un moyen (12 à 17) pour recevoir le signal émis ($y_T(n)$) ;
 - un moyen de décision (18 à 22) pour obtenir du signal reçu ($y_R(n)$) un signal de décision ($\hat{a}_R(n)$) correspondant à une estimation du signal ($a_T(n)$) à l'entrée de l'émetteur (1) ;
 - un moyen de commande (23 à 31) coopérant avec ledit moyen de décision (18 à 22) pour produire ledit signal de commande ($C_i$) ;
 - un moyen (32) pour émettre ledit signal de commande ($C_i$) sur la voie de retour ;

 **caractérisé en ce que** ledit moyen de commande (23 à 31) comprend :

 - un moyen (23, 24) pour reconstituer un modèle de référence ($s_R(n)$) du signal émis ($y_T(n)$), tel qu'il est reçu ($y_R(n)$) par le récepteur (2), à partir dudit signal de décision ($\hat{a}_R(n)$) ;
 - un moyen (25, 26) pour produire un signal d'erreur ($e_R(n)$) indicatif de la différence entre le signal reçu ($y_R(n)$) et ledit modèle de référence ($s_R(n)$), et
 - un moyen (27 à 31) pour corréler ledit modèle de référence ($s_R(n)$) et ledit signal d'erreur ($e_R(n)$) afin d'obtenir ledit signal de commande ($C_i$).

10. Système selon la revendication précédente, **caractérisé en ce que** ledit dispositif distorsif (9) est un amplificateur de puissance radioélectrique.

11. Système selon la revendication 9 ou 10, **caractérisé en ce que** le moyen de corrélation (27 à 31) comprend :

 - un moyen d'élévation au carré (27) pour calculer le module quadratique dudit modèle de référence ($s_R(n)$) ;
 - un premier multiplicateur (28) de la sortie dudit moyen d'élévation au carré (27) par le modèle de référence ($s_R(n)$) ;

**EP 1 280 272 B1**

- un deuxième multiplicateur (29) de la sortie du moyen d'élévation au carré (27) par la sortie du premier multiplicateur (28) ;
- un troisième multiplicateur (30) de la sortie du premier multiplicateur (28) par ledit signal d'erreur ($e_R(n)$), pour obtenir des coefficients de corrélation du troisième degré ($C_1$) du modèle de référence ($s_R(n)$) et du signal d'erreur ($e_R(n)$), et
- un quatrième multiplicateur (31) de la sortie du deuxième multiplicateur (29) par ledit signal d'erreur ($e_R(n)$), pour obtenir des coefficients de corrélation du cinquième degré ($C_1$) du modèle de référence ($s_R(n)$) et du signal d'erreur ($e_R(n)$).

12. Système selon l'une quelconque des revendications 9 à 11, **caractérisé en ce que** ledit moyen de reconstitution (*, 23, 24) comprend un moyen (*, 23) pour exécuter un redressement ($e^{-j\phi(n)}$) dudit signal de décision ($â_R(n)$) de la phase de la porteuse récupérée ($e^{j\phi(n)}$).

13. Système selon la revendication précédente, **caractérisé en ce que** ledit moyen de reconstitution (*, 23, 24) comprend un filtre FIR (24) à coefficients adaptatifs pour filtrer le signal de décision redressé.

**Fig. 1**

**Fig. 2**

EP 1 280 272 B1

Frequency [MHz]